# EUROPÄISCHE PATENTANMELDUNG

(11) **EP 1 538 555 A2**
(43) Veröffentlichungstag der Anmeldung: **08.06.2005**
(21) Anmeldenummer: 04000202.4
(22) Anmeldetag: 08.01.2004
(51) Int. Cl.: G06K 19/07

(54) **Transponder mit zwei unterschiedlichen Modulationsverfahren**

(30) Priorität: 04.12.2003 DE 10301451
(71) Anmelder: ATMEL Germany GmbH, 74072 Heilbronn (DE)
(72) Erfinder: Fischer, Martin, Dipl.-Ing., 74629 Gleichen (DE); Friedrich, Ulrich, Dipl.-Ing. (FH), 74258 Ellhofen (DE)

(57) **Zusammenfassung**

2.1. Die Erfindung bezieht sich auf ein Verfahren zur drahtlosen Datenübertragung zwischen einer Basisstation und einer Sende- und Empfangseinrichtung, bei dem die Basisstation elektromagnetische Wellen emittiert und diese durch die Sende- und Empfangseinrichtung empfangen und in Abhängigkeit von an die Basisstation zu übertragenden Daten mit einem ersten Modulationsverfahren moduliert und reflektiert werden, auf eine zur Durchführung dieses Verfahrens geeignete Sende- und Empfangseinrichtung sowie auf eine hierfür verwendbare Modulationseinrichtung.
2.2. Erfindungsgemäß werden in Abhängigkeit von der an der Sendeund Empfangseinrichtung empfangenen Feldstärke der elektromagnetischen Wellen die elektromagnetischen Wellen mit einem zweiten Modulationsverfahren zusätzlich oder alternativ zum ersten Modulationsverfahren moduliert und reflektiert.
2.3. Verwendung z.B. in Transpondern.

## Beschreibung

Die Erfindung bezieht sich auf ein Verfahren zur drahtlosen Datenübertragung zwischen einer Basisstation und einer Sende- und Empfangseinrichtung nach dem Oberbegriff des Anspruchs 1, auf eine zur Durchführung dieses Verfahrens geeignete Sende- und Empfangseinrichtung sowie auf eine hierfür verwendbare Modulationseinrichtung.

Systeme, bei denen zwischen einer oder mehreren Basisstationen bzw. Lesegeräten und einem oder mehreren sogenannten Transpondern, elektronischen Datenträgern, draht- bzw. kontaktlos Daten übertragen werden, werden z.B. als kontaktlose Identifikationssysteme oder sogenannte RFID-Systeme eingesetzt. Auf dem Transponder können auch Sensoren, beispielsweise zur Temperaturmessung, integriert sein. Derartige Transponder werden auch als Remote-Sensoren bezeichnet. Die Transponder bzw. deren Sende- und Empfangseinrichtungen verfügen üblicherweise nicht über einen aktiven Sender für die Datenübertragung zur Basisstation. Bei derartigen nicht aktiven Systemen, die als passive Systeme bezeichnet werden, wenn sie keine eigene Energieversorgung aufweisen, und als semipassive Systeme bezeichnet werden, wenn sie eine eigene Energieversorgung aufweisen, wird zur Datenübertragung bei Entfernungen von deutlich mehr als einem Meter in Verbindung mit UHF oder Mikrowellen in der Regel die sogenannte Backscatter- oder Rückstreukopplung eingesetzt. Hierzu werden von der Basisstation elektromagnetische Wellen emittiert, die durch die Sende- und Empfangseinrichtung des Transponders entsprechend der an die Basisstation zu übertragenden Daten mit einem Modulationsverfahren moduliert und reflektiert werden. Dies geschieht im allgemeinen durch eine Eingangsimpedanzänderung der Sende- und Empfangseinrichtung, die eine Veränderung der Reflexionseigenschaften einer daran angeschlossenen Antenne bewirkt. Hierfür sind unterschiedliche Verfahren bekannt.

Bei einem ersten Verfahrenstyp, der beispielsweise in der EP 1 211 635 A2 beschrieben ist, wird der Realteil der Eingangsimpedanz durch Zu- bzw. Abschalten einer im wesentlichen ohmschen Last verändert, wodurch hauptsächlich eine Amplitudenänderung oder Amplitudenmodulation der reflektierten Wellen bewirkt wird. Dieses Modulationsverfahren wird als Amplitudentastung (ASK) bezeichnet. Die ohmsche Last belastet als zusätzlicher Verbraucher die Spannungsversorgung des Transponders, wodurch die maximal überbrückbare Entfernung zwischen Transponder und Basisstation, insbesondere bei passiven Transpondern ohne eigene Energieversorgung, erheblich verringert wird.

Bei einem zweiten Verfahrenstyp wird der Imaginärteil der Eingangsimpedanz durch Veränderung der Kapazität eines Kondenstors im Eingangsteil der Sende- und Empfangseinrichtung beeinflusst, wodurch hauptsächlich eine Phasenänderung oder Phasenmodulation der reflektierten Wellen bewirkt wird. Dieses Modulationsverfahren wird als Phasenumtastung (PSK) bezeichnet. Ein derartiges Verfahren ist beispielsweise in der älteren deutschen Patentanmeldung 10158442.3 der Anmelderin dargestellt. Im Vergleich zur ASK beeinflusst dieses Modulationsverfahren die Betriebsspannung praktisch nicht, wodurch ein hoher Wirkungsgrad des Transponders erzielbar ist und die maximal überbrückbare Entfernung zwischen Transponder und Basisstation zunimmt. Allerdings nimmt die vom Transponder reflektierte Leistung ab, wenn der Abstand zwischen Transponder und Basisstation kleiner wird. Bei sehr kleinen Entfernungen kann der Fall auftreten, dass die Basisstation das vom Transponder reflektierte, phasenmodulierte Signal nicht mehr detektieren kann.

Der Erfindung liegt als technisches Problem die Bereitstellung eines Verfahrens, einer zugehörigen Sende- und Empfangseinrichtung sowie einer Modulationseinrichtung zugrunde, welche eine zuverlässige Datenübertragung zum Beispiel zwischen einer Basisstation und einem passiven oder semipassiven Transponder über einen weiten Entfernungsbereich, beginnend bei relativ kleinen Abständen bis hin zu relativ großen Abständen, ermöglichen.

Die Erfindung löst dieses Problem durch die Bereitstellung eines Verfahrens mit den Merkmalen des Anspruchs 1, einer Sende- und Empfangseinrichtung mit den Merkmalen des Anspruchs 8 sowie einer Modulationseinrichtung nach Anspruch 16.

Bei dem erfindungsgemäßen Verfahren wird in Abhängigkeit von der an der Sende- und Empfangseinrichtung empfangenen Feldstärke der elektromagnetischen Wellen ein zweites Modulationsverfahren zusätzlich oder alternativ zum ersten Modulationsverfahren verwendet. Dies ermöglicht einen sicheren Betrieb der Sende- und Empfangseinrichtung über einen weiten Entfernungsbereich hinweg, da die beiden Modulationsverfahren so kombinierbar sind, dass sich für jede Entfernung eine ausreichende Modulationsleistung einstellt.

In einer Weiterbildung des Verfahrens nach Anspruch 2 wird das zweite Modulationsverfahren bei Überschreiten einer einstellbaren Schwellen-Feldstärke verwendet bzw. aktiviert. Eine derartige Aktivierung erhöht die erzielbare Entfernung zwischen Basisstation und Sende- und Empfangseinrichtung, da bei großen Entfernungen und dadurch bedingten kleinen Feldstärken nur ein Modulationsverfahren aktiv ist, das spezifisch auf diesen Entfernungsbereich ausgelegt werden kann, und verbessert gleichzeitig die Betriebsicherheit im Nahbereich bei großen Feldstärken, wenn die Schwellen-Feldstärke überschritten ist, da hier genügend Strahlungsleistung zur Verfügung steht, um ein weiteres Modulationsverfahren zu betreiben.

In einer Weiterbildung des Verfahrens nach Anspruch 3 wird das Überschreiten der Schwellen-Feldstärke mit Hilfe einer Referenzspannung und/oder eines Referenzstroms detektiert. Eine Aktivierung des zusätzlichen Modulationsverfahrens lässt sich dabei einfach, beispielsweise mit Hilfe eines Komparators, durchführen.

In einer Weiterbildung der Erfindung nach Anspruch 4 bzw. 9 ist das erste Modulationsverfahren eine Phasenumtastung und/oder das zweite Modulationsverfahren eine Amplitudentastung. Mit Hilfe der Phasenumtastung lassen sich große Entfernungen zwischen Basisstation und Sende- und Empfangseinheit erzielen und sie ist schaltungstechnisch einfach umzusetzen. Die Amplitudentastung stellt insbesondere im Nahbereich ein robustes Übertragungsverfahren dar.

In einer Weiterbildung des Verfahrens nach Anspruch 5 wird der Modulationsgrad des zweiten Modulationsverfahrens in Abhängigkeit von der empfangenen Feldstärke geregelt. Dies ermöglicht eine optimale Einstellung der Modulationsleistung und vermeidet somit unnötigen Stromverbrauch.

In einer Weiterbildung des Verfahrens nach Anspruch 6 wird zur Amplitudentastung der Sollwert eines Reglers verändert. Bei dem Regler kann es sich um einen beliebigen Reglertyp, insbesondere Spannungs- oder Stromregler, handeln.

In einer Weiterbildung des Verfahrens nach Anspruch 7 wird zur Amplitudentastung der Arbeitspunkt einer Begrenzerschaltung verändert und/oder in eine Spannungsvervielfacherschaltung eingegriffen. Beide Maßnahmen sind einfach durchzuführen und auch schaltungstechnisch einfach zu realisieren. Beim Eingriff in die Spannungsvervielfacherschaltung ist ein hoher Wirkungsgrad erzielbar, da ein in der Regel nach dem Gleichrichter angeordneter Glättungskondensator bzw. Lastkondensator durch die Modulationseinrichtung nicht belastet wird.

Die Sende- und Empfangseinrichtung nach Anspruch 8 eignet sich zur Durchführung des erfindungsgemäßen Verfahrens. Sie weist hierzu zusätzlich zu einer ersten eine zweite Modulationseinrichtung auf, die in Abhängigkeit von der empfangenen Feldstärke zusätzlich oder alternativ zur ersten Modulationseinrichtung aktivierbar ist.

In einer Weiterbildung der Sende- und Empfangseinrichtung nach Anspruch 10 ist die zweite Modulationseinrichtung an die Ausgangsseite eines Gleichrichters angekoppelt. Dadurch wird verhindert, dass sich die parasitären Eigenschaften der Bauelemente der zweiten Modulationseinrichtung im Hochfrequenzbereich eingangsseitig, d.h. am Antenneneingang, auswirken.

In einer Weiterbildung der Sende- und Empfangseinrichtung nach Anspruch 11 beinhaltet die zweite Modulationseinrichtung einen Regler, insbesondere einen Spannungsregler, und Referenzmittel, insbesondere Zenerdioden mit unterschiedlicher Zenerspannung, wobei die Referenzmittel zur Sollwerteinstellung des Reglers dienen. Mit Hilfe des Reglers lassen sich unter anderem die Auswirkungen der Amplitudentastung regeln.

In einer Weiterbildung der Sende- und Empfangseinrichtung nach Anspruch 12 umfasst die zweite Modulationseinrichtung eine Begrenzerschaltung mit mehreren Dioden, die seriell in Durchlassrichtung zwischen eine Versorgungsspannung und ein Bezugspotential eingeschleift sind, und ein ansteuerbares Schaltmittel, das zwischen einen Verbindungspunkt zweier Dioden und das Bezugspotential eingeschleift ist, mit einem Steuereingang, der mit einem Modulationssteuersignal beaufschlagt ist. Eine derartige Schaltungsanordnung lässt sich einfach und kostengünstig herstellen und ist einfach mit der ersten Modulationseinrichtung kombinierbar. Eine Amplitudentastung erfolgt erst bei Überschreitung einer Begrenzungsspannung der Begrenzerschaltung und wird durch Änderung des Arbeitspunkts der Begrenzerschaltung mit Hilfe des Schaltmittels synchron zum Modulationssteuersignal bewirkt.

In einer Weiterbildung der Sende- und Empfangseinrichtung nach Anspruch 13 umfasst die zweite Modulationseinrichtung eine Serienschaltung von Dioden, die in Durchlassrichtung zwischen eine Versorgungsspannung und ein Bezugspotential eingeschleift sind, ein ansteuerbares Schaltmittel, das zwischen die Versorgungsspannung und das Bezugspotential eingeschleift ist, und ein logisches Gatter. Das geeignet verschaltete logische Gatter dient zur feldstärkeabhängigen Freischaltung des Schaltmittels. So kann sichergestellt werden, dass unterhalb einer einstellbaren Feldstärke, d.h. bei geringer Strahlungsleistung, keine Amplitudentastung stattfindet.

In einer Weiterbildung der Sende- und Empfangseinrichtung nach Anspruch 14 ist das Schaltmittel zwischen einen Knoten einer Stufe einer Spannungsvervielfacherschaltung und das Bezugspotential eingeschleift. Die Amplitudentastung erfolgt hier ebenfalls erst ab einer einstellbaren Schwellen-Feldstärke durch einen Eingriff in die Spannungsvervielfacherschaltung.

In einer Weiterbildung der Sende- und Empfangseinrichtung nach Anspruch 15 ist der Transponder passiv oder semipassiv. Die erfindungsgemäße Kombination von mindestens zwei getrennt aktivierbaren Modulationseinrichtungen ist insbesondere für passive Transponder vorteilhaft, da im Nahfeld der Basisstation bei ausreichender Strahlungsleistung eine hohe Modulationsleistung sichergestellt ist und im Fernfeld bei geringer Strahlungsleistung ausschließlich eine energiesparende Modulationsvariante verwendbar ist.

Bei der Modulationseinrichtung zur Amplitudentastung nach Anspruch 16 ist ein Knoten einer Stufe einer mehrstufigen Spannungsvervielfacherschaltung mit einem Schaltmittel verbunden, welches den Knoten in Abhängigkeit von einem Ansteuersignal mit einem Bezugspotential verbindet. Dies ermöglicht eine effiziente Amplitudentastung, bei der sich die parasitären Eigenschaften der Bauelemente der Modulationseinrichtung im Hochfrequenzbereich eingangsseitig nicht auswirken. Gleichzeitig wird ein eventuell zur Glättung der Ausgangsspannung der Spannungsvervielfacherschaltung verwendeter Kondensator nur unwesentlich durch Schaltvorgänge im Zusammenhang mit der Modulation belastet.

Vorteilhafte Ausführungsformen der Erfindung sind in den Zeichnungen dargestellt und werden nachfolgend beschrieben. Hierbei zeigen:
- Fig. 1: ein schematisches Schaltbild einer ersten erfindungsgemäßen Sende- und Empfangseinrichtung, bei der eine Amplitudentastung mit Hilfe eines Spannungsreglers erfolgt,
- Fig. 2: ein schematisches Schaltbild einer zweiten erfindungsgemäßen Sende- und Empfangseinrichtung, bei der die Amplitudentastung mit Hilfe einer Begrenzerschaltung erfolgt, deren Arbeitspunkt verstellt wird,
- Fig. 3: ein schematisches Schaltbild einer dritten erfindungsgemäßen Sende- und Empfangseinrichtung, bei der eine Diodenstrecke zur Erzeugung einer Referenzspannung benutzt wird, die zur Freigabe der Amplitudentastung dient,
- Fig. 4: ein schematisches Schaltbild einer vierten erfindungsgemäßen Sende- und Empfangseinrichtung, bei der zur Amplitudentastung in eine mehrstufige Spannungsvervielfacherschaltung innerhalb eines Gleichrichters eingegriffen wird, und
- Fig. 5: ein schematisches Schaltbild einer Spannungsvervielfacherschaltung gemäß Fig. 4 mit Modulationseingriff.

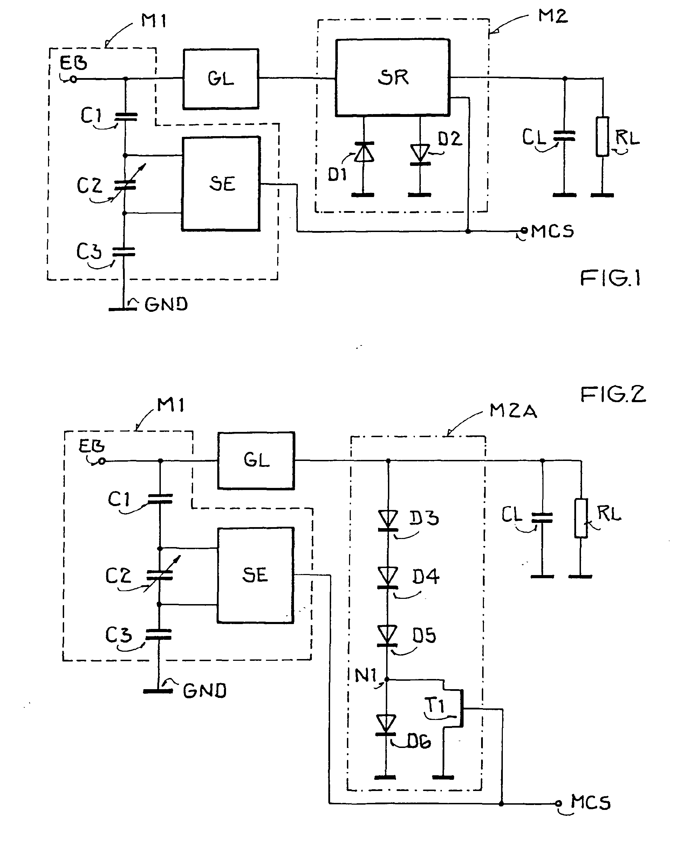

Fig. 1 zeigt eine Sende- und Empfangseinrichtung für einen passiven oder semipassiven Transponder zur bidirektionalen Kommunikation mit einer nicht gezeigten Basisstation, bei der es sich um eine beliebige, mit dem Transponder kommunizierende Komponente handeln kann. Eine erste Modulationseinrichtung M1 dient zur Durchführung eines ersten Modulationsverfahrens in Form einer Phasenumtastung. Sie umfasst einen ersten Kondensator C1, einen zweiten, spannungssteuerbaren Kondensator C2 in Form eines MOS-Varaktors, einen dritten Kondensator C3 und eine Steuereinheit SE zur Ansteuerung des Kondensators C2. Eine zweite Modulationseinrichtung M2 zur Durchführung eines zweiten Modulationsverfahrens in Form einer Amplitudentastung beinhaltet einen Spannungsregler SR mit zwei Referenzelementen in Form von Zenerdioden D1 und D2 mit unterschiedlichen Zenerspannungen. Weiterhin ist ein Gleichrichter GL vorgesehen, der intern aus mehreren Stufen aufgebaut sein kann. Eine kapazitive Last CL und eine ohmsche Last RL repräsentieren die jeweiligen Lastkomponenten von nachfolgenden, hier nicht näher interessierenden und daher nicht detailliert gezeigten Schaltungsteilen des Transponders, wobei die kapazitive Last CL zur Glättung der Ausgangsspannung des Gleichrichters GL dient. Eine nicht gezeigte Antenne wird mit einer Eingangsbuchse EB und einem Bezugspotential GND verbunden. Ein Modulationssteuersignal MCS dient zur Ansteuerung der Steuereinheit SE und des Spannungsreglers SR.

Die Basisstation emittiert elektromagnetische Wellen, beispielsweise im UHF-Bereich, die von der Antenne empfangen werden. Ein Teil der Leistung der elektromagnetischen Wellen dient der elektrischen Versorgung des Transponders, der andere Teil wird in Abhängigkeit von zur Basisstation zu übertragenden Daten moduliert und reflektiert. Das am Eingangsteil zwischen der Eingangsbuchse EB und dem Bezugspotential GND anliegende Wechselspannungssignal wird mit Hilfe des Gleichrichters GL gleichgerichtet und dem Spannungsregler SR zugeführt. An einem Ausgang des Spannungsreglers SR sind die kapazitive und die ohmsche Last CL bzw. RL angeschlossen.

Die Kondensatoren C1, C2 und C3 der ersten Modulationseinrichtung M1 sind in Serie zwischen die Eingangsbuchse EB und das Bezugspotential GND eingeschleift. Der spannungssteuerbare Kondensator C2 ist an seinen beiden Anschlüssen mit jeweils einem Ausgang der Steuereinheit SE verbunden. Die Steuereinheit SE wird mit dem Steuersignal MCS beaufschlagt und gibt an den Kondensator C2 eine vom Steuersignal MCS abhängige Steuerspannung aus. Die Kapazität des Kondensators C2 stellt sich entsprechend der Steuerspannung ein. Eine Änderung des Steuersignals MCS bewirkt folglich eine Änderung der Eingangsimpedanz der Sende- und Empfangseinrichtung zwischen der Eingangsbuchse EB und dem Bezugspotential GND, wobei im wesentlichen nur der Imaginärteil der Eingangsimpedanz beeinflusst wird. Diese Impedanzänderung führt zu einer Veränderung der Reflexionseigenschaften der Antenne und dadurch zu einer Phasenänderung bzw. Phasenmodulation der von der Antenne reflektierten elektromagnetischen Wellen. Der Verlauf des Steuersignals MCS repräsentiert eine zu übertragende Daten- bzw. Bitfolge. Die Kondensatoren C1 und C3 bewirken eine DC-Entkopplung der am Kondensator C2 angelegten Steuerspannung bezüglich den Reflexionseigenschaften der Antenne, da die Frequenz des Steuersignals MCS klein gegenüber der Frequenz der elektromagnetischen Wellen ist.

Die erste Modulationseinrichtung M1 ist unabhängig von der empfangenen Feldstärke der elektromagnetischen Wellen aktiv, vorausgesetzt, dass überhaupt genügend Leistung zum Betrieb des Transponders zur Verfügung steht. Die zweite Modulationseinrichtung M2 trägt erst ab dem Überschreiten einer durch die Zenerspannungen der Zenerdioden D1 bzw. D2 bestimmten Schwellen-Feldstärke zur Modulation bei. Vorteilhafterweise erfolgt die Dimensionierung der Zenerspannungen derart, dass bei hoher Feldstärke im Nahbereich der Basisstation ein Rückgang der Modulationsleistung der Phasenumtastung durch die Modulationsleistung der zweiten Modulationseinrichtung zur Amplitudentastung zumindest kompensiert wird. Ein dadurch bedingter Anstieg der Verlustleistung in einer ohmschen Last ist im Nahbereich unkritisch, da ausreichend Strahlungsleistung für die Versorgung des Transponders zur Verfügung steht.

Das Modulationssteuersignal MCS schaltet im Spannungsregler SR zwischen den Zenerdioden D1 bzw. D2 als jeweils aktiviertes Bauelement zur Spannungssollwertvorgabe um, d.h. die an den Zenerdioden D1 bzw. D2 abfallende Spannung dient dem Spannungsregler SR als Sollwertvorgabe. Wenn die Ausgangsspannung am Gleichrichter GL größer ist als beide Zenerspannungen der Zenerdioden D1 bzw. D2, sind diese jeweils bei Aktivierung leitend, wodurch der Sollwert und dadurch die Ausgangsspannung des Spannungsreglers SR zwischen den entsprechenden Zenerspannungen alterniert. Aufgrund dieser Ausgangspannungsänderung und der angeschlossenen Last RL und CL ändert sich im wesentlichen der Realteil der Eingangsimpedanz, wodurch eine Amplitudentastung der reflektierten Wellen bewirkt wird. Beide Modulationsverfahren sind aktiv und überlagern sich.

Unterhalb einer Schwellen-Feldstärke und einer daraus resultierenden Schwellen-Spannung nach dem Gleichrichter GL ist hingegen keine der beiden Zenerdioden D1 bzw. D2 leitend. Die an ihnen anliegende Spannung bei Aktivierung ist dann für beide Zenerdioden D1 und D2 in etwa gleich der am Ausgang des Gleichrichters GL anliegenden Spannung. Unabhängig vom Modulationssteuersignal MCS ist der Sollwert und dadurch die Ausgangsspannung des Spannungsreglers SR folglich in etwa gleich der Ausgangsspannung des Gleichrichters GL. Eine Amplitudentastung findet nicht statt.

In einem Zwischenspannungsbereich, in dem die Ausgangsspannung des Gleichrichters GL größer ist als die Zenerspannung der Diode mit der kleinerer Zenerspannung, aber kleiner als die Zenerspannung der Diode mit der größeren Zenerspannung alterniert der Sollwert und dadurch die Ausgangsspannung des Spannungsreglers SR zwischen der kleineren Zenerspannung und der Ausgangsspannung des Gleichrichters GL. Dies bewirkt eine Amplitudentastung mit reduziertem Modulationsgrad.

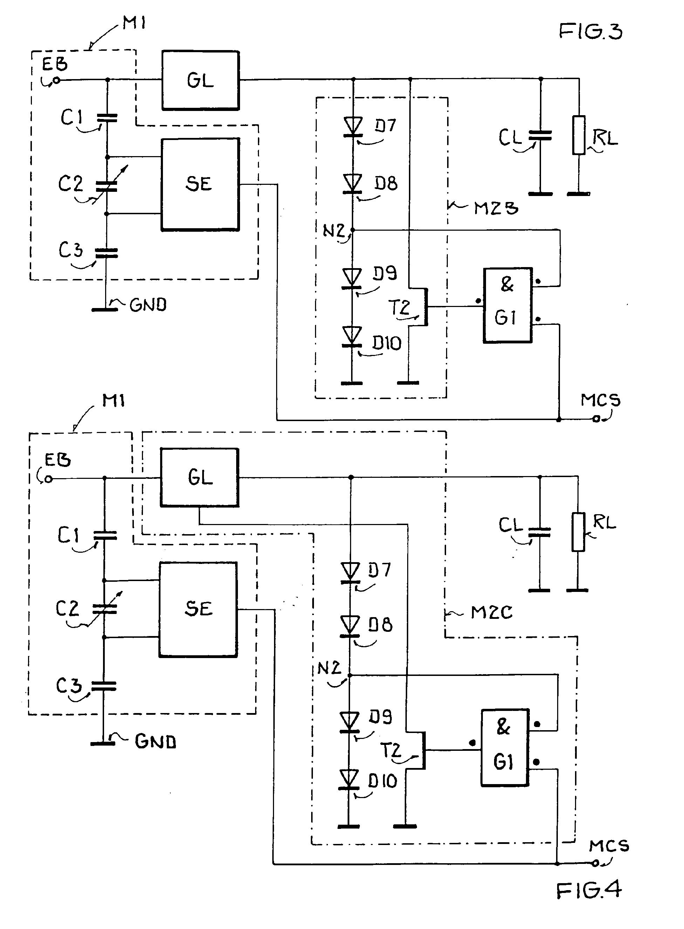

Fig. 2 zeigt eine zweite Sende- und Empfangseinrichtung, bei der die Amplitudentastung mit Hilfe einer Begrenzerschaltung erfolgt, deren Arbeitspunkt verstellt wird. Die hier gezeigte Vorrichtung unterscheidet sich von der in Fig. 1 gezeigten lediglich durch die Ausführung der zweiten Modulationseinrichtung M2 zur Amplitudentastung, die hier als M2A bezeichnet ist. Die zweite Modulationseinrichtung M2A umfasst Dioden D3 bis D6, die als Reihenschaltung in Durchlassrichtung zwischen eine Versorgungsspannung, d.h. den Ausgang des Gleichrichters GL, und ein Masse-Bezugspotential GND eingeschleift sind, und einen MOS-Transistor T1, der mit einem Anschluss seines Drain-Source-Kanals mit einem Verbindungspunkt N1 zwischen der Diode D5 und der Diode D6 verbunden ist, und mit dem anderen Anschluss seines Drain-Source-Kanals auf GND liegt. Ein Steuereingang des Transistors T1 wird mit dem Modulationssteuersignal MCS beaufschlagt.

Die zweite Modulationseinrichtung M2A trägt auch hier erst ab dem Überschreiten einer Schwellenspannung am Ausgang des Gleichrichters GL zur Modulation bei. Wenn die Ausgangsspannung unterhalb der Summe der Durchlassspannungen der Dioden D3 bis D6 liegt, ist die Diodenstrecke nicht leitend, daher wirkt sich die Beaufschlagung des Transistors T1 mit dem Modulationssteuersignal MCS nicht aus. Wenn die Ausgangsspannung über der Summe der Durchlassspannungen liegt, wird bei durchgeschaltetem Transistor T1 die Diode D6 überbrückt, was bewirkt, dass die Ausgangsspannung um ca. den Betrag der Durchlassspannung der Diode D6 abnimmt. Ein alternierendes Modulationssteuersignal MCS bewirkt also eine um den Betrag der Durchlassspannung der Diode D6 alternierende Spannung an der Ausgangsseite des Gleichrichters GL. Wie bereits bei Fig. 1 erläutert, führt dies zu einer Änderung des Realteils der Eingangsimpedanz, wodurch eine Amplitudentastung des reflektierten Signals bewirkt wird. In diesem Arbeitsbereich sind beide Modulationsverfahren aktiv und überlagern sich.

Fig. 3 zeigt eine dritte Sende- und Empfangseinrichtung, bei der eine Diodenstrecke zur Erzeugung einer Referenzspannung benutzt wird, die zur Freigabe der Amplitudentastung dient. Die hier gezeigte Vorrichtung unterscheidet sich von den zuvor gezeigten wiederum lediglich durch die Ausführung der zweiten Modulationseinrichtung M2 zur Amplitudentastung, die hier als M2B bezeichnet ist. Die zweite Modulationseinrichtung M2B umfasst Dioden D7 bis D10, die wie in Fig. 2 beschaltet sind, einen MOS-Transistor T2, der mit einem Anschluss seines Drain-Source-Kanals mit der Versorgungsspannung verbunden ist und mit dem anderen Anschluss seines Drain-Source-Kanals auf GND liegt, und ein UND-Gatter G1. Ein erster Eingang des Gatters G1 wird mit dem Modulationssteuersignal MCS beaufschlagt und ein zweiter Eingang ist mit einem Verbindungspunkt N2 zwischen der Diode D8 und der Diode D9 verbunden. Ein Steuereingang des Transistors T2 ist mit einem Ausgang des Gatters G1 verbunden.

Die am Knoten N2 anliegende Referenzspannung dient als Freigabesignal für die Amplitudentastung. Wenn die Ausgangsspannung des Gleichrichters GL nicht ausreicht, um die Diodenstrecke leitend zu machen, liegt an dem mit dem Knoten N2 verbundenen Eingang des Gatters G1 eine logische "0" an. Der Ausgang des Gatters G1 liegt daher auf "0", d.h. der Transistor T2 sperrt. Die zweite Modulationseinrichtung M2B bleibt trotz Ansteuerung durch das Modulationssteuersignal MCS inaktiv. Eine Freigabe, d.h. eine Aktivierung, erfolgt erst ab einem ausreichenden Spannungspegel am Ausgang des Gleichrichters GL, der erst bei entsprechend hoher Feldstärke gegeben ist.

Wenn ein ausreichender Spannungspegel zur Aktivierung vorhanden ist, entspricht das Ausgangssignal des Gatters G1 dem Modulationssteuersignal MCS, wodurch der Transistor T2 synchron zum Modulationssteuersignal MCS eine Lastmodulation am Ausgang des Gleichrichters GL bewirkt. Diese Lastmodulation resultiert dann in einer Amplitudentastung.

Fig. 4 zeigt eine Abwandlung der in Fig. 3 gezeigten Schaltungsanordnung, bei der die Amplitudentastung von einer charakteristisch ausgelegten, erfindungsgemäßen Modulationsschaltung bewirkt wird, bei welcher der Gleichrichter GL eine mehrstufige Spannungsvervielfacherschaltung beinhaltet, in die durch ein Schaltmittel eingegriffen wird. Die Modulationseinrichtung zur Amplitudentastung ist hier als M2C bezeichnet. Im Unterschied zu Fig. 3 ist der Drain-Source-Kanal des Transistors T2, der als Schaltmittel fungiert, zwischen eine Stufe der Spannungsvervielfacherschaltung innerhalb des Gleichrichters GL und Masse eingeschleift.

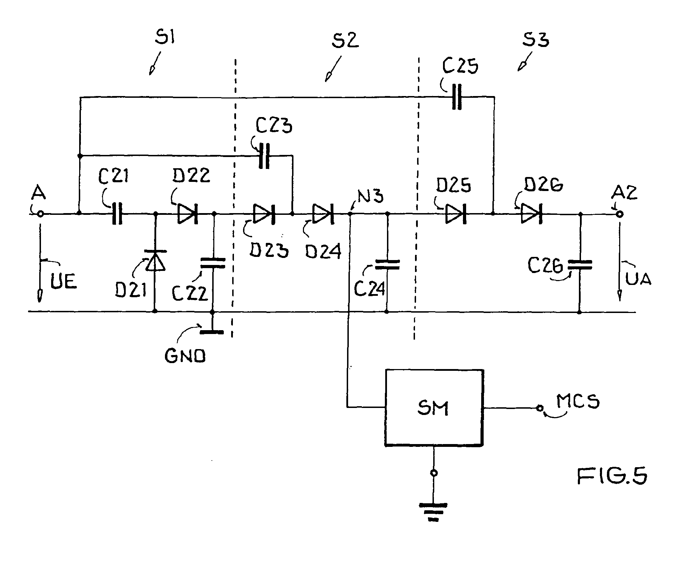

Fig. 5 zeigt im Schaltbild die Spannungsvervielfacherschaltung mit Modulationseingriff. Die Spannungsvervielfacherschaltung ist exemplarisch aus drei Stufen S1 bis S3 aufgebaut, die in Serie zwischen einem Eingang und einem Ausgang der Spannungsvervielfacherschaltung angeordnet sind, wobei eine beliebige Anzahl derartiger Stufen, beispielsweise in Abhängigkeit von der gewünschten Ausgangsspannung, koppelbar sind. Die Eingangsspannung UE wird zwischen einen Eingangspol A1 und ein Bezugspotential, im allgemeinen Masse bzw. GND, angelegt. Die Ausgangsspannung UA kann an einem Ausgangspol A2 abgegriffen werden. Ein Ausgang der vorhergehenden Stufe ist jeweils mit einem Eingang der nachfolgenden Stufe gekoppelt.

Die erste Stufe S1 umfasst zwei Kondensatoren C21 und C22 und zwei Dioden D21 und D22. Ein Anschluss des Kondensators C21 ist mit dem Eingangspol A1, der andere mit der Kathode der Diode D21 und mit der Anode der Diode D22 verbunden. Die Anode der Diode D21 und ein Anschluss des Kondensators C22 sind mit dem Bezugspotential verbunden. Der andere Anschluss des Kondensators C22 und die Kathode der Diode D22 sind miteinander verbunden und bilden zusammen mit dem Bezugspotential den Ausgang der ersten Stufe S1.

Die zweite Stufe S2 umfasst zwei Kondensatoren C23 und C24 sowie zwei Dioden D23 und D24. Die Anode der Diode D23 ist mit einem Ausgangspol der ersten Stufe S1 verbunden. Die Dioden D23 und D24 sind in Serie zwischen einen Eingangspol und einen Ausgangspol der zweiten Stufe S2 in Durchlassrichtung eingeschleift. Zwischen den Ausgangspol und das Bezugspotential ist der Kondensator C24 eingeschleift. Die erste Stufe S1 ist mit der zweiten Stufe S2 zusätzlich über den Kondensator C23 gekoppelt, der an einem Anschluss mit dem Eingangspol A1 und mit seinem anderen Anschluss mit der Kathode der Diode D23 und mit der Anode der Diode D24 verbunden ist.

Die dritte Stufe S3 umfasst zwei Kondensatoren C25 und C26 sowie zwei Dioden D25 und D26. Sie ist in gleicher Weise wie die zweite Stufe S2 aufgebaut.

Zur Amplitudentastung ist der Ausgang der zweiten Stufe S2 mit einem Schaltmittel SM, beispielsweise dem Transistor T2 von Fig. 4, verbunden. Das Schaltmittel SM verbindet den Ausgang synchron zu einem Ansteuersignal, beispielsweise dem Modulationssteuersignal MCS von Fig. 4, mit einem Bezugspotential, beispielsweise Masse. Dies bewirkt eine Amplitudenänderung der reflektierten Wellen.

Der Vorteil eines derartigen Eingriffs in eine Stufe eines mehrstufigen Gleichrichters im Vergleich zu einer geschalteten Last nach dem Gleichrichter ist, dass die kapazitive Last CL durch den Schaltvorgang nicht zusätzlich belastet wird.

Anstatt der gezeigten Stufen S1 bis S3 können auch Stufen in Delon/Greinacher-Schaltung und/oder Stufen in Villard-Schaltung verwendet werden, bei denen ein Ausgang einer Stufe mit dem Schaltmittel SM verbunden ist.

Wie aus der obigen Beschreibung einiger exemplarischer Ausführungsformen deutlich wird, stellt die Erfindung ein Verfahren und zugehörige Schaltungsanordnungen zur Verfügung, die eine zuverlässige Datenübertragung zwischen einer Basisstation und einem passiven Transponder über einen weiten Entfernungsbereich, beginnend bei relativ kleinen Abständen bis hin zu relativ großen Abständen, ermöglichen. Die Schaltungsanordnungen sind einfach in Transponder-Designs zu integrieren.

## Patentansprüche

1. Verfahren zur drahtlosen Datenübertragung zwischen einer Basisstation und einer Sende- und Empfangseinrichtung, insbesondere eines Transponders, bei dem die Basisstation elektromagnetische Wellen emittiert und diese durch die Sende- und Empfangseinrichtung empfangen und in Abhängigkeit von an die Basisstation zu übertragenden Daten mit einem ersten Modulationsverfahren moduliert und reflektiert werden,
**dadurch gekennzeichnet, dass**
in Abhängigkeit von der an der Sende- und Empfangseinrichtung empfangenen Feldstärke der elektromagnetischen Wellen die elektromagnetischen Wellen mit einem zweiten Modulationsverfahren zusätzlich oder alternativ zum ersten Modulationsverfahren moduliert und reflektiert werden.

2. Verfahren nach Anspruch 1, **dadurch gekennzeichnet, dass** das zweite Modulationsverfahren bei Überschreiten einer einstellbaren Schwellen-Feldstärke verwendet wird.

3. Verfahren nach Anspruch 2, **dadurch gekennzeichnet, dass** das Überschreiten der Schwellen-Feldstärke mit Hilfe einer Referenzspannung und/oder eines Referenzstroms detektiert wird.

4. Verfahren nach einem der vorhergehenden Ansprüche, **dadurch gekennzeichnet, dass** das erste Modulationsverfahren eine Phasenumtastung und/oder das zweite Modulationsverfahren eine Amplitudentastung ist.

5. Verfahren nach einem der vorhergehenden Ansprüche, **dadurch gekennzeichnet, dass** der Modulationsgrad des zweiten Modulationsverfahrens in Abhängigkeit von der empfangenen Feldstärke geregelt wird.

6. Verfahren nach Anspruch 4 oder 5, **dadurch gekennzeichnet, dass** zur Amplitudentastung der Sollwert eines Reglers (SR) verändert wird.

7. Verfahren nach einem der Ansprüche 4 bis 6, **dadurch gekennzeichnet, dass** zur Amplitudentastung der Arbeitspunkt einer Begrenzerschaltung verändert und/oder in eine Spannungsvervielfacherschaltung eingegriffen wird.

8. Sende- und Empfangseinrichtung, insbesondere für Transponder, mit
- einer ersten Modulationseinrichtung (M1), die von einer Basisstation emittierte elektromagnetische Wellen in Abhängigkeit von an die Basisstation zu übertragenden Daten moduliert,
**gekennzeichnet durch**
- eine zweite Modulationseinrichtung (M2, M2A, M2B, M2C), die in Abhängigkeit von der an der Sende- und Empfangseinrichtung empfangenen Feldstärke zusätzlich oder alternativ zur ersten Modulationseinrichtung (M1) aktivierbar ist.

9. Sende- und Empfangseinrichtung nach Anspruch 8, **dadurch gekennzeichnet, dass** die erste Modulationseinrichtung (M1) für eine Phasenumtastung und/oder die zweite Modulationseinrichtung (M2, M2A, M2B, M2C) für eine Amplitudentastung ausgebildet ist.

10. Sende- und Empfangseinrichtung nach Anspruch 8 oder 9, **dadurch gekennzeichnet, dass** die zweite Modulationseinrichtung (M2, M2A, M2B, M2C) an die Ausgangsseite eines Gleichrichters (GL) angekoppelt ist.

11. Sende- und Empfangseinrichtung nach einem der Ansprüche 8 bis 10, **dadurch gekennzeichnet, dass** die zweite Modulationseinrichtung (M2) einen Regler, insbesondere einen Spannungsregler (SR), und Referenzmittel, insbesondere Zenerdioden (D1, D2), umfasst, wobei die Referenzmittel zur Sollwerteinstellung des Reglers dienen.

12. Sende- und Empfangseinrichtung nach einem der Ansprüche 8 bis 10, **dadurch gekennzeichnet, dass** die zweite Modulationseinrichtung (M2A) folgende Elemente umfasst:
- eine Begrenzerschaltung mit mehreren Dioden (D3, D4, D5, D6), die seriell in Durchlassrichtung zwischen eine Versorgungsspannung und ein Bezugspotential eingeschleift sind, und
- ein ansteuerbares Schaltmittel (T1), das zwischen einen Verbindungspunkt (N1) zweier Dioden (D5, D6) und das Bezugspotential eingeschleift ist, mit einem Steuereingang, der mit einem Modulationssteuersignal (MCS) beaufschlagt ist.

13. Sende- und Empfangseinrichtung nach einem der Ansprüche 8 bis 10, **dadurch gekennzeichnet, dass** die zweite Modulationseinrichtung (M2B) folgende Elemente umfasst:
- eine Serienschaltung von Dioden (D7, D8, D9, D10), die in Durchlassrichtung zwischen eine Versorgungsspannung und ein Bezugspotential eingeschleift sind,
- ein ansteuerbares Schaltmittel (T2), das zwischen die Versorgungsspannung und das Bezugspotential eingeschleift ist, und
- ein logisches Gatter, insbesondere ein UND-Gatter (G1), von dem ein Ausgang mit einem Steuereingang des Schaltmittels (T2) verbunden ist, ein Eingang mit einem Verbindungspunkt (N2) zweier Dioden (D8, D9) verbunden ist und ein weiterer Eingang mit einem Modulationssteuersignal (MCS) beaufschlagt ist.

14. Sende- und Empfangseinrichtung nach einem der Ansprüche 8 bis 10, **dadurch gekennzeichnet, dass** die zweite Modulationseinrichtung (M2C) folgende Elemente umfasst:
- eine Serienschaltung von Dioden (D7, D8, D9, D10), die in Durchlassrichtung zwischen eine Versorgungsspannung und ein Bezugspotential eingeschleift sind,
- ein ansteuerbares Schaltmittel (T2), das zwischen einen Knoten (N3) einer Stufe (S2) einer Spannungsvervielfacherschaltung und das Bezugspotential eingeschleift ist und
- ein logisches Gatter, insbesondere ein UND-Gatter (G1), von dem ein Ausgang mit einem Steuereingang des Schaltmittels (T2) verbunden ist, ein Eingang mit einem Verbindungspunkt (N2) zweier Dioden (D8, D9) verbunden ist und ein weiterer Eingang mit einem Modulationssteuersignal (MCS) beaufschlagt ist.

15. Sende- und Empfangseinrichtung nach einem der Ansprüche 8 bis 14, **dadurch gekennzeichnet, dass** der Transponder passiv oder semipassiv ist.

16. Modulationseinrichtung (M2C) zur Amplitudentastung für eine Sende- und Empfangseinrichtung, die von einer Basisstation emittierte elektromagnetische Wellen in Abhängigkeit von an die Basisstation zu übertragenden Daten moduliert, mit
- einem Gleichrichter (GL), der eine mehrstufige Spannungsvervielfacherschaltung umfasst,
**dadurch gekennzeichnet, dass**
- ein Knoten (N3), insbesondere ein Ausgangsknoten, einer Stufe (S2) der mehrstufigen Spannungsvervielfacherschaltung mit einem Schaltmittel (T2, SM) verbunden ist, welches den Knoten (N3) in Abhängigkeit von einem Ansteuersignal (MCS) mit einem Bezugspotential verbindet.
